# EUROPÄISCHE PATENTSCHRIFT

(11) **EP 0 549 854 B1**
(45) Veröffentlichungstag und Bekanntmachung des Hinweises auf die Patenterteilung: **20.03.1996**
(21) Anmeldenummer: 92111759.4
(22) Anmeldetag: 10.07.1992
(51) Int. Cl.: H01J 37/34, C23C 14/34

(54) **Kathode zum Beschichten eines Substrats**
Cathode for coating a substrate
Cathode de revêtement d'un substrat

(30) Priorität: 28.12.1991 DE 4143135
(43) Veröffentlichungstag der Anmeldung: 07.07.1993
(73) Patentinhaber: LEYBOLD AKTIENGESELLSCHAFT, D-63450 Hanau (DE)
(72) Erfinder: Wolf, Bernd, W-6450 Hanau (DE); Müller, Jürgen, Dr., W-6000 Frankfurt 50 (DE); Neudert, Hans, W-6463 Freigericht (DE)

(56) Entgegenhaltungen:
- EP-A- 0 337 012
- EP-A- 0 541 903
- DE-A- 3 727 901
- US-A- 4 401 539

## Beschreibung

Die Erfindung betrifft eine Kathode zum Beschichten eines Substrats, die an eine Gleichstrom- und/oder Wechselstromquelle (Hochfrequenzquelle) angeschlossen und in eine evakuierbaren Beschichtungskammer angeordnet ist, und die elektrisch mit einem Target in Verbindung steht, das zerstäubt wird und dessen zerstäubte Teilchen sich auf dem Substrat niederschlagen, wobei in die Beschichtungskammer ein Prozeßgas einbringbar ist und die Kathode aus einem im wesentlichen topfförmigen Gehäuse gebildet ist, dessen geschlossenes Bodenteil mit seiner Außenfläche mit dem Target fest verbunden, vorzugsweise verschraubt ist und dessen dem Target abgewandtes, offenes Ende in einer Öffnung in der Außenwand der Beschichtungskammer abgedichtet so gehalten ist, daß der Innenraum des Gehäuses stets dem Atmosphärendruck ausgesetzt ist, während das Target und die Außenfläche des mit diesem verbundenen, in die Beschichtungskammer hineinragenden, hülsenförmigen Teils des Gehäuses vom in der Beschichtungskammer jeweils herrschenden Druck beaufschlagt sind.

Bekannt ist eine Zerstäubungskathode nach dem Magnetronprinzip (DE-A-37 27 901) mit einem aus mindestens einem Teil bestehenden Target aus dem zu zerstäubenden Material, mit einem hinter dem Target angeordneten Magnetsystem mit Magneteinheiten abwechselnd unterschiedlicher Polung, durch die mindestens ein in sich geschlossener magnetischer Tunnel aus bogenförmig gekrümmten Feldlinien gebildet wird, wobei die dem Target abgekehrten Pole der Magneteinheiten über ein Magnetjoch aus weichmagnetischem Werkstoff miteinander verbunden sind, wobei zumindest einer der Permamentmagnete durch einen Elektromagneten beeinflußt ist. Schließlich ist bereits eine Kathode zum Beschichten eines Substrats des eingangs genannten Typs in einer älteren, nicht vorveröffentlichten Anmeldung (EP-A-541 903) beschrieben, bei der das hinter dem Target angeordnete Magnetsystem ausschließlich mit Permamentmagneten oder einem Elektromagnet bestückt ist.

Der vorliegenden Erfindung liegt die Aufgabe zugrunde, eine Sputterkathode zu schaffen, die so in bzw. an der Beschichtungskammer angeordnet werden kann, daß ihre Magnetanordnung auch dann zugänglich ist, also beispielsweise austauschbar ist, wenn die Beschichtungskammer evakuiert ist, deren Platzbedarf im Vergleich zu herkömmlichen Kathoden besonders gering ist, die auch für einen Ultra-Hochvakuumprozeß bei Temperaturen von etwa 200 bis 400° C betrieben werden kann und deren Magnetanordnung besonders leistungsfähig und in weiten Grenzen auf den Prozeß abstimmbar ist.

Diese Aufgabe wird erfindungsgemäß durch eine Kathode gemäß dem Anspruch gelöst.

Die Erfindung läßt die verschiedensten Ausführungsmöglichkeiten zu; eine davon ist in der Zeichnung schematisch näher dargestellt, die den Längsschnitt durch die Sputterkathode mit angeschraubtem Target und durch eine Ebene, die die Kühlkanäle und die Kühlmittelanschlüsse aufweist, zeigt.

Die dem Substrat 46 gegenüberliegend angeordnete Kathode besteht im wesentlichen aus einem topfförmigen, aus mehreren Teilen gebildeten Gehäuse 3, zwei im Boden des topfförmigen Gehäuses 3 gehaltenen Permanentmagneten 4, 5, von denen der eine eine kreisringzylindrische und der andere eine kreizylindrische Konfiguration aufweist, aus einem etwa kreiszylindrischen Magnetjoch 6, aus der in dieses eingesetzten kreisringzylindrisch ausgeformten Spule bzw. Elektromagneten 61, und aus einem topfförmigen Einsatz 8, der die Anschlußstutzen 9, 10 für die Kühlkanäle 11, 12 und die Bohrung 56 für das Anschlußkabel 60 für den Elektromagneten 61 enthält und der mit Hilfe nicht näher dargestellter, radial verstellbarer Bolzen am Gehäuse 3 verriegelbar ist.

Das topfförmige Gehäuse 3 besteht aus einem Flansch 23 zur Halterung der Kathode an der Wand 30 der Prozeßkammer, den beiden Profilringen 24, 25, dem zwischen den beiden Profilringen 24, 25 angeordneten Keramikring 26, dem wassergekühlten äußeren Hülsenteil 27, der aufgelöteten Bodenplatte 58, dem Target 29 und der eingelöteten Gewindehülse 59.

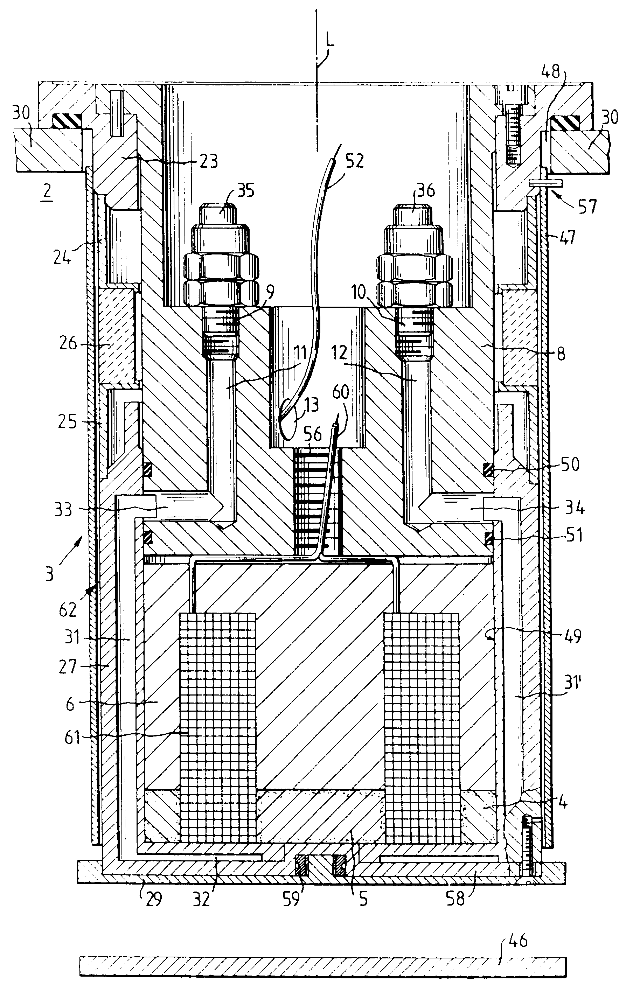

Wie aus Figur 1 ersichtlich, durchdringen die Bohrungen 31, 31', ... den zylindrischen Körper und verbinden im Hohlraum 32 den Kühlkreislauf zwischen Vor- und Rücklauf. Diese Bohrungen bzw. Hohlräume 31, 31', ... bzw. 32 korrespondieren mit Anschlußbohrungen 33 bzw. 34, die im Einsatz 8 vorgesehen sind und die wiederum mit den Kühlkanälen 11, 12 verbunden sind, die ihrerseits über die Verschraubungen oder Stutzen 9, 10 an die Kühlmittelleitung 35, 36 angeschlossen sind. Die Bohrung bzw. Öffnung 56 ermöglicht den Einbau eines Elektromagneten 61 mit dem zugehörigen Magnetjoch 6.

Die vorstehend beschriebene Kathode hat den Vorteil, daß sich der Kühlmantel bzw. die vom Kühlmittel durchflossenen Hohlräume 31, 31', ... bzw. 32 außen befinden, während die Kühlmittelanschlüsse 9, 10 innen sind, so daß eine Leckage in der Kühlmittelzuleitung nicht zu einem Kühlmitteleinbruch in die Prozeßkammer 2 führen kann. Die Kühlmittelanschlüsse können auch ohne weiteres von den Verschraubungen bzw. den Anschlußstutzen 9, 10 gelöst werden, ohne daß die Prozeßkammer 2 belüftet werden muß.

Darüber hinaus kann der Magneteinsatz bei evakuierter Prozeßkammer 2 ausgetauscht werden, und es kann der Abstand zwischen den Magneten 4, 5 und dem Target 29 verändert werden, ohne daß die Prozeßkammer 2 geöffnet bzw. geflutet werden muß. Zum Aufheizen der Kathode läßt sich auch der Einsatz 8 und der an diesem befestigte Magnetsatz 4, 5, 6, 61 einfach nach hinten bzw. oben zu aus der Kathode entfernen.

Es sei noch erwähnt, daß die Stromzuführung 52 zum Hülsenteil 27 bzw. zum Target 29 über die oben erwähnten Verriegelungsbolzen erfolgt, die unter Vorspannung gehalten und radial nach außen gedrückt werden (nicht näher dargestellt), so daß ein sicherer Stromübergang zwischen den Verriegelungsbolzen und der Hülse 27 gewährleistet ist.

Der HF-beständige Einsatz 8 ist schließlich mit Hilfe von Rundschnurringen (Dichtringen) 50, 51 so gegenüber der Innenwand des Gehäuses 3 abgedichtet, daß das Kühlmittel nur von den Anschlußbohrungen 33, 34 aus in den Hohlraum bzw. Zwischenraum 32 bzw. die Bohrungen 31, 31' eintreten kann.

Die Bodenplatte 58 ist mit dem zylindrischen Teil 27 an allen Kontaktstellen vakuumgelötet. Zu der Bodenplatte 58 ist eine Gewindehülse 59 zwecks mittiger Targetbefestigung eingelötet.

Schließlich sei noch erwähnt, daß das Gehäuse 3 der Kathode von einer rohrförmigen Dunkelraumabschirmung 47 umschlossen ist, die mit Hilfe einer Renkverbindung 57 am Flansch 23 befestigt ist, und daß die Teile 23 und 24 bzw. die Teile 25 und 27 durch Schweißen und die Teile 24 und 26 bzw. 26 und 25 durch Hartlöten miteinander verbunden sind und daß der Flansch 23 des Gehäuses 3 mit dem sich radial nach außen zu erstreckenden Kragen des Einsatzes 8 verschraubt ist.

### Bezugszeichenliste

- 2: Beschichtungskammer
- 3: Gehäuse
- 4: Permanentmagnet
- 5: Permanentmagnet
- 6: Magnetjoch
- 8: Einsatz
- 9: Anschlußstutzen
- 10: Anschlußstutzen
- 11: Kühlkanal
- 12: Kühlkanal
- 23: Flansch
- 24: Profilring
- 25: Profilring
- 26: ringförmiges Zwischenstück, Isolierring
- 27: Hülsenteil (außen)
- 29: Target
- 30: Wand der Prozeßkammer
- 31, 31', ...: Bohrung
- 32: Hohlraum
- 33: Anschlußbohrung
- 34: Anschlußbohrung
- 35: Kühlmittelleitung
- 36: Kühlmittelleitung
- 46: Substrat
- 47: Dunkelraumabschirmung
- 48: Öffnung
- 49: Innenraum des Gehäuses
- 50: Ringdichtung
- 51: Ringdichtung
- 52: elektrischer Leiter
- 53: elektrischer Leiter
- 56: Gewindebohrung
- 57: Renkverbindung
- 58: Bodenplatte
- 59: Gewindehülse
- 60: Anschlußkabel
- 61: Elektromagnet, Spule
- 62: Gehäuseaußenfläche

## Patentansprüche

1. Kathode zum Beschichten eines Substrats (46), die an eine Gleichstrom- und/oder Wechselstromquelle (Hochfrequenzquelle) angeschlossen und in einer evakuierbaren Beschichtungskammer (2) angeordnet ist und die elektrisch mit einem Target (29) in Verbindung steht, das zerstäubt wird und dessen zerstäubte Teilchen sich auf dem Substrat (46) niederschlagen,
wobei in die Beschichtungskammer (2) ein Prozeßgas einbringbar ist und die Kathode aus einem im wesentlichen topfförmigen Gehäuse (3) gebildet ist, dessen geschlossenes Bodenteil (58) mit seiner Außenfläche mit dem Target (29) fest verbunden, vorzugsweise verschraubt ist und
dessen dem Target (29) abgewandtes, offenes Ende in einer Öffnung (48) in der Außenwand (30) der Beschichtungskammer (2) abgedichtet so gehalten ist, daß der Innenraum (49) des Gehäuses (3) stets dem Atmosphärendruck ausgesetzt ist, während das Target (29) und die Außenfläche (62) des mit diesem verbundenen, in die Beschichtungskammer (2) hineinragenden, hülsenförmigen Teils des Gehäuses (3) vom in der Beschichtungskammer (2) jeweils herrschenden Druck beaufschlagt sind und mit einem den Innenraum (49) des Gehäuses (3) zumindest teilweise ausfüllenden Einsatz (8), der mit der Gehäuseinnenwand so verriegelbar ist, daß er mit dem Bodenteil (58) einen etwa kreiszylindrischen Raum bildet, in den ein einen Elektromagneten (61) einschließender Magnetsatz (5, 4, 61) mit Joch (6) eingesetzt ist,
wobei die Permanentmagnete (4, 5) des Magnetsatzes aus einem kreisringzylindrischen und einem von diesem ringförmig umschlossenen kreiszylindrischen Magneten gebildet sind,
wobei die kreisringzylindrische Spule des Elektromagneten (61) mit ihrem dem Bodenteil(58) des Gehäuses (3) zugekehrten Ende in einen von den beiden Magneten (4, 5) gebildeten Ringraum hineinragt,
wobei das dem Bodenteil (58) abgekehrte Ende der Spule des Elektromagneten (61) in eine diesem Endteil angepaßte Ausnehmung des im übrigen kreiszylindrischen Jochs (6) einfaßt und in dieser kreisringzylindrischen Ausnehmung gehalten ist.

## Claims

1. A cathode for coating a substrate (46), which cathode is connected to a d.c.- and/or a.c. source (high-frequency source) and is arranged in a coating chamber (2) which can be evacuated and is electrically connected to a target (29) which is sputtered and the sputtered particles of which are deposited on the substrate (46), where a process gas can be introduced into the coating chamber (2) and the cathode is formed by a substantially cup-shaped housing (3) the closed base member (58) of which is permanently connected, preferably screwed, by its outer surface to the target (29), and the open end of which, which faces away from the target (29), is retained in sealed fashion in an opening (48) in the outer wall (30) of the coating chamber (2) in such manner that the interior (49) of the housing (3) is always exposed to the atmospheric pressure, while the target (29) and the outer surface (62) of the sleeve-shaped part of the housing (3) which is connected to the target and projects into the coating chamber (2) is acted upon by the pressure in each case prevailing in the coating chamber (2) and with an insert (8) which at least partially fills the interior (49) of the housing (3) and which can be locked to the inner wall of the housing in such manner that with the base member (58) it forms an approximately circular-cylindrical space into which a magnet assembly (5, 4, 61) with a yoke (6) and enclosing an electromagnet (61) is inserted, where the permanent magnets (4, 5) of the magnet assembly are formed by a ring-cylindrical magnet and a circular-cylindrical magnet surrounded by the latter in annular fashion, where the ring-cylindrical coil of the electromagnet (61) projects, with its end facing towards the base member (58) of the housing (3), into an annular space formed by the two magnets (4, 5), where that end of the coil of the electromagnet (61) facing away from the base member (58) fits into a recess, adapted to this end member, of the otherwise circular-cylindrical yoke (6) and is retained in this ring-cylindrical recess.

## Revendications

1. Cathode de revêtement d'un substrat (46) qui est reliée à une source de courant continu et/ou de courant alternatif (source de haute fréquence) et qui est disposée dans une chambre de revêtement (2) qui peut être mise sous vide et qui est électriquement reliée à une cible (29) que l'on pulvérise et dont les particules pulvérisées se déposent sur le substrat (46), cathode dans le cas de laquelle un gaz de processus peut être introduit dans la chambre de revêtement (2) et dans le cas de laquelle la cathode est formée d'un boîtier (3) sensiblement en forme de boisseau dont le fond (58), fermé, est, par sa surface extérieure, solidarisé, de préférence vissé, avec la cible (29) et
dont la partie ouverte, située du côté opposé à la cible (29), est maintenue, avec étanchéité, dans une ouverture (40) prévue dans la paroi extérieure (30) de la chambre de revêtement (2) de façon telle que l'espace intérieur (49) du boîtier (3) est en permanence exposé à la pression atmosphérique, tandis que la cible (29) et la surface extérieure (62) de la partie du boîtier (3) en forme de douille, liée à la cible et pénétrant dans la chambre de revêtement (2), sont sous la pression régnant chaque fois dans la chambre de revêtement (2) et cathode comportant une garniture (8) qui remplit, au moins partiellement, l'espace intérieur (49) du boîtier (3) et qui peut se verrouiller avec la paroi intérieure du boîtier de façon à former avec le fond (58) un espace à peu près cylindrique circulaire dans lequel est logé un ensemble d'aimants (5, 4, 61), comprenant un électroaimant (61), avec une culasse (6),
les aimants permanents (4, 5) de l'ensemble d'aimants étant formés d'un aimant en forme de cylindre annulaire circulaire et d'un aimant en forme de cylindre circulaire, entouré par celui en forme d'anneau.
la bobine en forme de cylindre annulaire circulaire de l'électroaimant (61) pénétrant, par son extrémité orientée vers le fond (58) du boîtier (3), dans un espace annulaire formé par les deux aimants (4, 5),
l'extrémité, orientée du côté opposé au fond (58), de la bobine de l'électro-aimant (61) s'enchâssant dans un évidement, correspondant à cette extrémité, de la culasse (6), par ailleurs en forme de cylindre circulaire, et étant maintenue dans cet évidement en forme de cylindre annulaire circulaire.
